# EUROPEAN PATENT APPLICATION

(11) **EP 4 711 969 A1**
(43) Date of publication of application: **18.03.2026**
(21) Application number: 23936488.8
(22) Date of filing: 22.12.2023
(51) Int. Cl.: G06F 30/20, G06F 9/46, G06V 10/764, G06V 20/13

(54) **DISTRIBUTED COMPUTING-BASED EARTH'S SURFACE ANOMALY DETECTION SATELLITE GROUP TASK PROCESS DESIGN METHOD**

(30) Priority: 08.05.2023 CN 202310512982
(71) Applicant: DFH Satellite Co., Ltd., Beijing 100094 (CN)
(72) Inventor: GAO, Han, Beijing 100094 (CN); ZHU, Jun, Beijing 100094 (CN); WANG, Chao, Beijing 100094 (CN); BAI, Zhaoguang, Beijing 100094 (CN); BAI, Yuchen, Beijing 100094 (CN); XU, Jun, Beijing 100094 (CN); LU, Zhiwei, Beijing 100094 (CN)
(74) Representative: Yalçiner Patent and Consulting Ltd.
(86) International application number: PCT/CN2023/140901
(87) International publication number: WO 2024/230184

(57) **Abstract**

A distributed computing-based earth's surface anomaly detection satellite group task process design method. Provided is an earth's surface anomaly detection satellite group task process design method, comprising: first classifying anomaly types on the basis of earth's surface anomaly priori knowledge; on the basis of an anomaly threshold lookup table, decomposing anomaly features; and using different types of satellites in a distributed satellite group to acquire the anomaly features layer by layer so as to complete anomaly recognition. The task process design for recognizing earth's surface anomalies by means of the coordination of multiple satellites provides a solution to difficulties in recognizing complex earth's surface anomaly phenomena. The present invention uses the threshold lookup table as a standard for anomaly recognition and uses a distributed satellite system to execute the complex earth's surface anomaly recognition, thereby providing references for overall design of satellite systems.

## Description

### CROSS-REFERENCE TO RELATED APPLICATION

The present disclosure claims priority to Chinese Patent Application No. 202310512982.1, filed on May 08, 2023, with the invention title "distributed computing-based earth's surface anomaly detection satellite group task process design method", the entire content of which is incorporated into the present disclosure by reference.

### FIELD

The present disclosure relates to a distributed computing-based earth's surface anomaly detection satellite group task process design method, which belongs to the field of remote sensing satellite overall design.

### BACKGROUND

In recent years, various sudden earth's surface anomalies caused by natural and human factors in China (such as natural disasters, environmental pollution, ecological damage, safety accidents, illegal development, etc.) have occurred frequently, showing the characteristics of wide distribution range, high occurrence frequency, fast evolution speed, large impact scope and heavy economic losses. These anomalies have not only brought serious losses to people's lives and property, but also exerted a huge impact on the production and life of the entire society (Wang Qiao et al., 2014). There are various types of earth's surface anomaly events with different driving mechanisms, and their corresponding remote sensing response characteristics (spectrum, scattering, geometry, texture, etc.) are complex. A single remote sensing image is difficult to meet the diagnostic needs for anomalies. At the same time, the existing on-board processing capacity is limited, and a single satellite cannot complete the semantic segmentation and diagnostic identification of complex anomalies. Distributed remote sensing technology is one of the emerging remote sensing technologies. It aims to establish a "distributed reconfigurable" satellite remote sensing system, utilizing a spatial system composed of a plurality of physically disconnected satellites that jointly fulfill the same spatial task.

Dong Yucui et al. proposed the use of a distributed reconfigurable system for distributed remote sensing and high-resolution synthetic aperture imaging (Patent No. 201910261676.9); Xia Zhenghuan et al. proposed a low-orbit small satellite distributed global navigation satellite system-scatter (GNSS-S) radar system, which uses distributed receiving satellites to receive and process GNSS-S echo signals from sea-going ship targets, performs fusion processing on distributed GNSS-S radar information, and realizes remote sensing of sea-going ships (Patent No. 202210314938.5); Ren Weijia et al. collected high-definition remote sensing images via low-orbit remote sensing satellites and could transmit remote sensing data to ground stations with the help of geosynchronous orbit satellites (Patent No. 201811652589.8). Existing literatures mainly use distributed systems to complete single-target acquisition or single-function implementation, and there is no relevant design for the working mode and task process of the space-based system for ubiquitous earth's surface anomaly detection. The present disclosure proposes a satellite group architecture with a threshold lookup table as a basis for distributed computing, driven by an anomaly detection task to achieve efficient information flow, solves the problem of working mode determination and task process design in ubiquitous earth's surface anomaly detection, and provide an overall solution for system-level task analysis and constellation design.

### SUMMARY

The technical problem solved by the present invention is: aiming at the problem that the existing space-based systems are difficult to realize the real-time identification and diagnosis of complex earth's surface anomalies, a distributed computing-based earth's surface anomaly detection satellite group task process design method is proposed, which uses the space-based system to realize the real-time identification and diagnosis of earth's surface anomalies.

The technical solution of the present disclosure is as follow: a distributed computing-based earth's surface anomaly detection satellite group task process design method, with the steps as follow.
establishing a threshold lookup table for classification remote sensing elements of earth's surface anomalies;
selecting a satellite valid payload capable of acquiring relevant detection elements according to an earth's surface anomaly detection requirement element in the established threshold lookup table;
configuring types of satellites according to the selected payload, designing a working mode of a constellation system, and determining a system information flow and a task flow;
a real-time remote sensing constellation performing a regular search on a region to acquire a remote sensing element, interpreting a remote sensing image via the threshold lookup table, preliminarily determining a type of an earth's surface anomaly according to a correlation degree of five types of thresholds, judging a complexity level of an anomaly according to a number of relevant threshold types, and initiating subsequent task planning according to the complexity level;
a discovery satellite distributing, according to a task complexity level, a planned task to a subsequent satellite, and the subsequent satellite, after receiving the task, performing autonomous task planning, performing detailed detection on the region, and further identifying the anomaly in detail according to the threshold lookup table; and
performing relay transmission of anomaly information.

Establishing the threshold lookup table for remote sensing elements of earth's surface anomalies includes:
dividing types of earth's surface anomalies into five major categories and several subcategories, in which the five major categories of anomalies includes water anomalies, artificial earth's surface anomalies, bare soil anomalies, vegetation-covered region anomalies, and near-earth's surface atmospheric anomalies, with several subcategories divided under each major category; and
establishing the threshold lookup table for the remote sensing elements of the earth's surface anomalies, in which the remote sensing elements of ground objects include: a radiation characteristic, a spectral characteristic, a geometric characteristic, a textural characteristic, a scattering characteristic; each type of ground object is quantitatively described via the above remote sensing elements and divided into four levels of correlation, namely a strong characteristic, a moderate characteristic, a weak characteristic, and a possibly no characteristic.

Selecting the satellite valid payload capable of acquiring the relevant detection elements according to the detection requirement includes:
decomposing element indicators according to the threshold lookup table established, determining requirements for a detection spectral band, a spectral resolution, a spatial resolution, and a signal-to-noise ratio of the detection elements, designing a corresponding payload scheme, setting a satellite cluster as a detection basic unit, establishing a "general survey + detailed survey" working mechanism within the satellite cluster, setting satellites with forward orbital positions within the satellite cluster as general survey satellites and satellites with rear orbital positions as detailed survey satellites, in which the general survey satellites distinguish anomaly major categories via the threshold lookup table, and the detailed survey satellites identify anomaly subcategories based on information of the anomaly major category provided by the general survey satellites.

Configuring types of satellite, designing the working mode of the constellation system, and determining the information flow and the task flow include:
configuring different types of satellites according to the selected valid payload capable of acquiring the relevant detection elements; laying out the constellation system according to an order of detection elements and a degree of element correlation; selecting an observation mode and the working mode; and determining the task flow for an observation work to acquire anomaly elements, in which a task source is an autonomous task planning initiated by general survey satellites, detailed survey satellites have on-board autonomous task planning capabilities, and observation elements acquired by satellites are transmitted within the system in a form of information flow and ultimately reach users.

The real-time remote sensing constellation performing the regular search on the region to acquiring the remote sensing element includes:
for a known forest and grassland-covered region, prioritize acquiring plant canopy data related to forests and grasslands, as well as multi-band infrared data used to prevent or determine forest and grassland fires; for a known water-covered region, prioritize acquiring backscatter data and multispectral /hyperspectral data; for a known artificial earth's surface region, prioritize acquiring high-resolution data; for a known bare soil region, prioritize acquiring multispectral and infrared data; and for a near-surface atmospheric region, prioritize acquiring hyperspectral, infrared and scattering data.

The complexity levels of anomalies are classified as:
an anomaly with one observation response characteristic and having a strong characteristic being identified as a simple anomaly;
an anomaly with two response characteristics being identified as a moderately complex anomaly; and
an anomaly with three or more response characteristics being identified as a complex anomaly.

A specific manner for the relay transmission of the anomaly information is as follows:
a general survey satellite preliminarily discovers the anomaly, transmits slices and position information to a subsequent satellite, and initiates a task simultaneously;
earth's surface anomaly information identified by both the general survey satellite and a detailed survey satellite are transmitted to ground via real-time links between general survey satellites;
both the general survey satellite and the detailed survey satellite have a capability to access an existing space-based information network, including data transmission, relay, Beidou short message, and an upcoming satellite network low-orbit communication system.

The advantages of the present disclosure compared with the prior art are as follows.
(1) The present disclosure discloses the distributed computing-based earth's surface anomaly detection satellite group task process design method, a space-based system architecture for ubiquitous earth's surface anomaly detection is established on the basis of the method. The problem that complex elements in earth's surface anomaly detection are difficult to detect in real time is solved via a distributed system.
(2) The present disclosure proposes to select the valid payload by taking the threshold lookup table for classification remote sensing elements of earth's surface anomalies as the basis of distributed computing, determine the working mode of the constellation system and the information flow mode, and realize the overall design of the task-driven constellation system.
(3) The present invention classifies and grades the earth's surface anomalies, and establishes connections between the earth's surface anomalies and major remote sensing characteristics, and designs the task process of the constellation system according to characteristics of the anomaly detection task. The design of the present disclosure can realize an efficient detection of the earth's surface anomalies by the constellation system.

### BRIEF DESCRIPTION OF THE DRAWINGS

FIG. 1 is a flow chart of the present disclosure.
FIG. 2 is a diagram of earth's surface anomaly classification of the present disclosure.
FIG. 3 is a schematic diagram of an information flow of an earth's surface anomaly detection constellation system of the present disclosure.
FIG. 4 is a schematic diagram of a working mode of an earth's surface anomaly detection constellation of the present disclosure.
FIG. 5 is a schematic diagram of a task information flow of an earth's surface anomaly detection satellite group of the present disclosure.
FIG. 6 is a schematic diagram of an information relay transmission mode of an earth's surface anomaly detection satellite group of the present disclosure.

### DETAILED DESCRIPTION

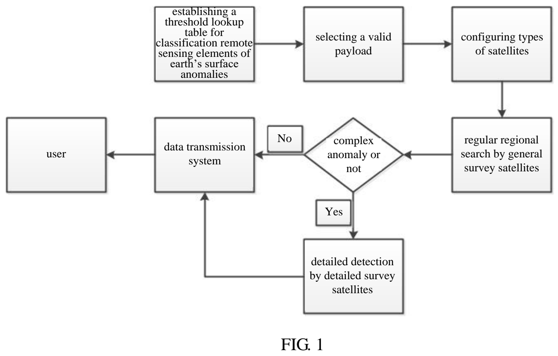

A distributed computing-based earth's surface anomaly detection satellite group task process design method, the flow chart of which is shown in FIG. 1, with the steps as follows:
(1) establishing a threshold lookup table for classification remote sensing elements of earth's surface anomalies;
(2) selecting a satellite valid payload capable of acquiring relevant detection elements according to an earth's surface anomaly detection requirement;
(3) configuring types of satellites, designing a working mode of a constellation system, and determining an information flow and a task flow; (real-time communication capability of node satellites)
(4) a real-time remote sensing constellation performing a regular search on an region, and after acquiring a remote sensing element, interpreting a remote sensing image via the threshold lookup table, preliminarily determining a type of an earth's surface anomaly, judging a complexity level of an anomaly, and initiating subsequent task planning;
(5) a discovery satellite distributing a planned task to a subsequent satellite, and the subsequent satellite, after receiving the task, performing autonomous task planning, performing detailed detection on the region, and further identifying the anomaly in detail according to the threshold lookup table; and
(6) performing relay transmission of anomaly information.

In step (1) above, the specific operations for establishing the threshold lookup table for remote sensing elements of earth's surface anomalies are as follows.

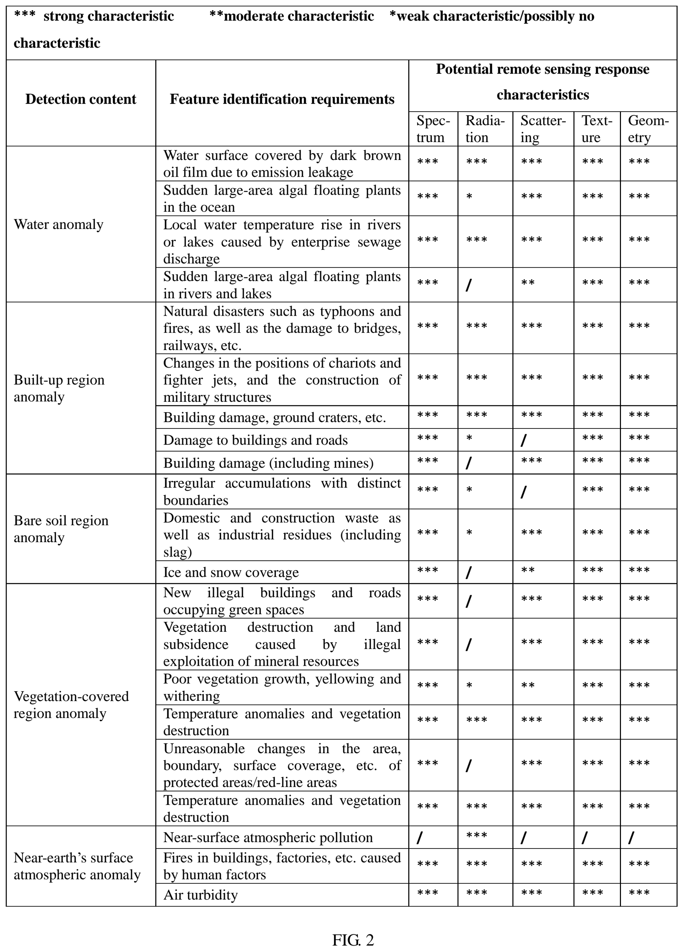

Main types of earth's surface anomalies are divided into five major categories and several subcategories. The five major categories of anomalies include water anomalies, artificial earth's surface (human living region) anomalies, bare soil (uninhabited region) anomalies, vegetation-covered region anomalies, and near-earth's surface atmospheric anomalies, with several subcategories divided under each major category, as shown in FIG. 2.

The threshold lookup table for the remote sensing elements of the earth's surface anomalies is established, where the remote sensing elements of ground objects include but are not limited to: a radiation characteristic, a spectral characteristic, a geometric characteristic, a textural characteristic, a scattering characteristic, etc. Each type of ground object can be quantitatively described via the above-mentioned remote sensing elements and divided into four levels of correlation, namely a strong characteristic, a moderate characteristic, a weak characteristic, and a possibly no characteristic, as shown in FIG. 2. By establishing the corresponding threshold lookup table for the remote sensing elements, a normal range of remote sensing characteristics of the ground object can be determined. When a threshold of the remote sensing element exceeds the normal range, it can be determined that an anomaly occurs.

In step (2) above, the specific operations for selecting the satellite valid payload according to the detection requirement are as follows.

According to characteristics of the detection elements of the earth's surface anomaly in step (1), element indicators are decomposed, and requirements for a detection spectral band, a spectral resolution, a spatial resolution, a signal-to-noise ratio (SNR), etc., of the detection elements are determined. A corresponding payload scheme is designed, and a satellite cluster is set as a detection basic unit. A "general survey + detailed survey" working mechanism is established within the satellite cluster, that is, front satellites in the satellite cluster is set as general survey satellites, and rear satellites is set as detailed survey satellites.

In step (3) above, the specific operations for configuring the types of satellites, designing the working mode of the constellation system, and determining the information flow and the task flow are as follows.

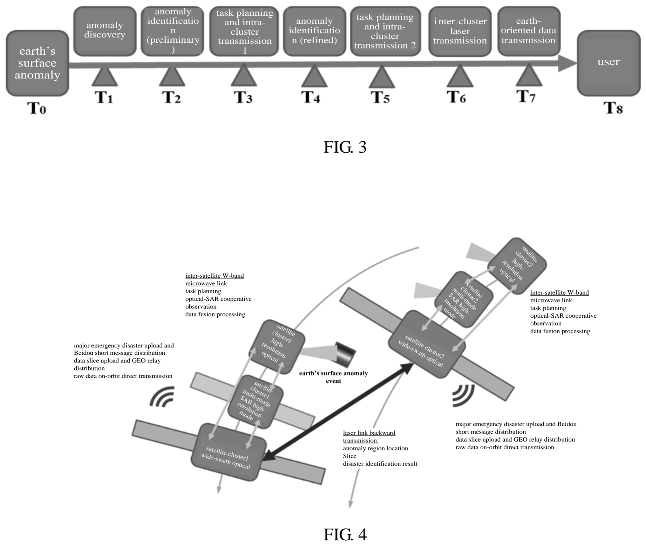

According to the payload scheme designed in step (2), different types of satellites are configured. A layout of the constellation system is determined according to an order of the detection elements and a degree of element correlation, an observation mode and the working mode are selected, and the task flow for an observation work to acquire anomaly elements is determined. A task source is an autonomous task planning initiated by the general survey satellites. The detailed survey satellites have on-board autonomous task planning capabilities. Observation elements acquired by the satellites are transmitted within the system in a form of information flow and ultimately reach users, with corresponding time points shown in FIG. 3. The constellation system operates driven by the task flow and the information flow.

In step (4) above, the specific implementation of the real-time remote sensing constellation performing the regular search on the region is as follows. Satellites have autonomous task planning capabilities and can perform regular monitoring on an earth's surface region, and perform targeted observation tasks on different plots based on prior knowledge. Specifically, for a known forest and grassland-covered region, priority is given to acquiring plant canopy data related to forests and grasslands, as well as multi-band infrared data that can prevent or determine forest and grassland fires. For a known water-covered region, priority is given to acquiring backscatter data and multispectral/hyperspectral data. For a known artificial earth's surface region, priority is given to acquiring high-resolution data. For a known bare soil region, priority is given to acquiring multispectral and infrared data. For a near-surface atmospheric region, the main data acquired are hyperspectral, infrared and scattering data.

In step (4) above, the complexity levels of anomalies are classified as follows.
1. An anomaly with one observation response characteristic and having the strong characteristic is identified as a simple anomaly.
2. An anomaly with two response characteristics is identified as a moderately complex anomaly.
3. An anomaly with three or more response characteristics is identified as a complex anomaly.

In step (6) above, the specific manner for information relay transmission is as follows.

The general survey satellites are acted as communication node satellites to establish an inter-satellite communication network. The general survey satellites have real-time communication capabilities between each other, and the general survey satellites and the detailed survey satellites have mutual data transmission capabilities. The general survey satellites support opportunistic accesses of the detailed survey satellites. The system itself has a capability to access an existing space-ground communication system. Inter-satellite communication has three capability characteristics as follows: 1. The general survey satellite preliminarily discovers the anomaly, transmits information such as slices and positions to a subsequent satellite, and initiates a task simultaneously; 2. Earth's surface anomaly information identified by both the general survey satellite and the detailed survey satellite can be transmitted to the ground via real-time links between general survey satellites; 3. Both the general survey satellite and detailed survey satellite have a capability to access an existing space-based information network, including data transmission, relay, Beidou short message, and an upcoming satellite network low-orbit communication system.

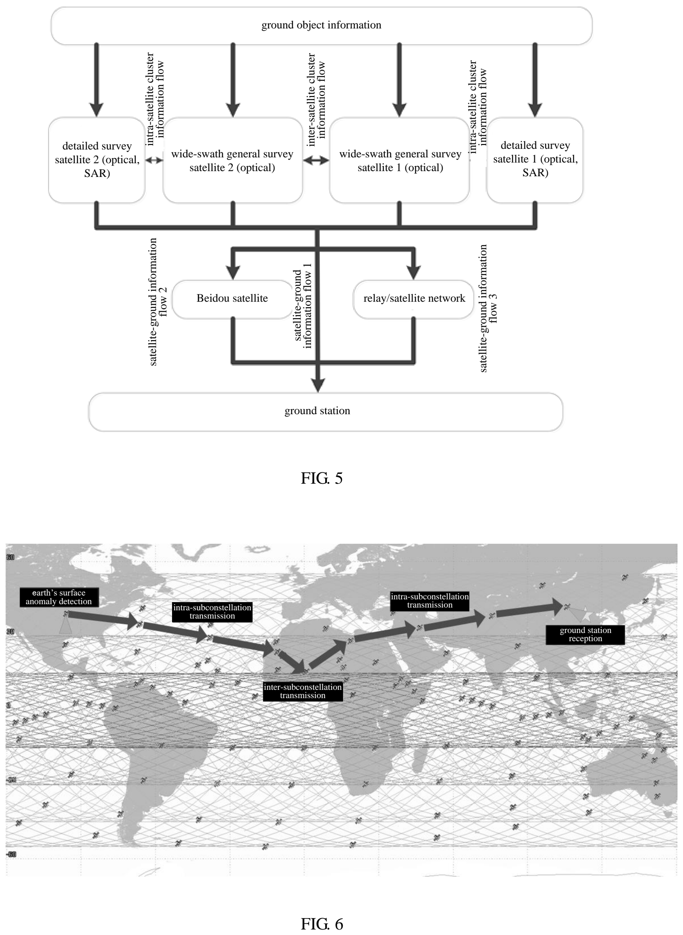

With a goal of earth's surface anomaly detection, a remote sensing classification diagram of earth's surface anomalies is established, and correlation relationships are shown in FIG. 2. In response to a detection requirement, three types of satellites are selected to form a satellite cluster to achieve functions. Satellite 1 is a wide-swath optical satellite, satellite 2 is a high-resolution optical satellite, and satellite 3 is a multi-mode synthetic aperture radar (SAR) satellite. The working mode of the constellation system is shown in FIG. 4. A target scenario is set. On February 6, 2023, a severe earthquake occurred in Turkey. After the earthquake, collapse, ground collapse, ground fissures and ground settlement occur. A real-time remote sensing constellation for earth's surface anomalies performs routine earth's surface anomaly identification work. At this time, the constellation flew over Turkey. First, the wide-swath satellite identified the occurrence of earth's surface anomaly phenomena in the Turkish region via earth's surface geometric and texture information, and preliminarily determined them as a Built-up region anomaly and a bare soil anomaly, mainly the Built-up region anomaly. At this time, a wide-swath satellite 1 transmitted slices and position information of the anomaly region to a high-resolution optical satellite 1 and a multi-mode SAR satellite 1, and also transmitted the anomaly slices and the position information to a wide-swath optical satellite 2 in the subsequent satellite cluster. The wide-swath optical satellite 2 then guided a high-resolution optical satellite 2 and a multi-mode SAR satellite 2 to conduct tracking observation of the earth's surface anomaly region. The earth's surface anomaly information confirmed by the high-resolution optical satellites and the multi-mode SAR satellites can be transmitted to ground users in three ways: via relay, Beidou downlink transmission, direct earth-oriented data transmission when entering a reception range of ground stations, and relay transmission to the ground via wide-swath optical satellites. The information flow is shown in FIG. 5, among which the main method used is the third one: relay downlink transmission to the ground with wide-swath optical satellites as communication nodes, as shown in FIG. 6.

Although the present disclosure has been disclosed above in preferred embodiments, it is not intended to limit the present disclosure. Any person skilled in the art may, without departing from the spirit and scope of the present disclosure, make possible changes and modifications to the technical solutions of the present disclosure by using the methods and technical contents disclosed above. Therefore, any simple modification, equivalent change and modification made to the above embodiments in accordance with the technical essence of the present disclosure, without departing from the content of the technical solutions of the present disclosure, shall fall within the protection scope of the technical solutions of the present disclosure.

## Claims

1. A distributed computing-based earth's surface anomaly detection satellite group task process design method, comprising:
establishing a threshold lookup table for classification remote sensing elements of earth's surface anomalies;
selecting a satellite valid payload capable of acquiring relevant detection elements according to an earth's surface anomaly detection requirement element in the established threshold lookup table;
configuring types of satellites according to the selected payload, designing a working mode of a constellation system, and determining a system information flow and a task flow;
a real-time remote sensing constellation performing a regular search on a region to acquire a remote sensing element, interpreting a remote sensing image via the threshold lookup table, preliminarily determining a type of an earth's surface anomaly according to a correlation degree of thresholds, judging a complexity level of an anomaly according to a number of relevant threshold types, and initiating subsequent task planning according to the complexity level;
a discovery satellite distributing, according to a task complexity level, a planned task to a subsequent satellite, and the subsequent satellite, after receiving the task, performing autonomous task planning, performing detailed detection on the region, and further identifying the anomaly in detail according to the threshold lookup table; and
performing relay transmission of anomaly information.

2. The distributed computing-based earth's surface anomaly detection satellite group task process design method according to claim 1, wherein establishing the threshold lookup table for remote sensing elements of earth's surface anomalies comprises:
dividing types of earth's surface anomalies into five major categories and several subcategories, wherein the five major categories of anomalies comprise water anomalies, artificial earth's surface anomalies, bare soil anomalies, vegetation-covered region anomalies, and near-earth's surface atmospheric anomalies, with several subcategories divided under each major category; and
establishing the threshold lookup table for the remote sensing elements of the earth's surface anomalies, wherein the remote sensing elements of ground objects comprise: a radiation characteristic, a spectral characteristic, a geometric characteristic, a textural characteristic, a scattering characteristic; each type of ground object is quantitatively described via the remote sensing elements and divided into four levels of correlation, namely a strong characteristic, a moderate characteristic, a weak characteristic, and a possibly no characteristic.

3. The distributed computing-based earth's surface anomaly detection satellite group task process design method according to claim 1, wherein selecting the satellite valid payload capable of acquiring the relevant detection elements according to the detection requirement comprises:
decomposing element indicators according to the threshold lookup table established, determining requirements for a detection spectral band, a spectral resolution, a spatial resolution, and a signal-to-noise ratio of the detection elements, designing a corresponding payload scheme, setting a satellite cluster as a detection basic unit, establishing a "general survey + detailed survey" working mechanism within the satellite cluster, setting satellites with forward orbital positions within the satellite cluster as general survey satellites and satellites with rear orbital positions as detailed survey satellites, wherein the general survey satellites distinguish anomaly major categories via the threshold lookup table, and the detailed survey satellites identify anomaly subcategories based on information of the anomaly major category provided by the general survey satellites.

4. The distributed computing-based earth's surface anomaly detection satellite group task process design method according to claim 1, wherein configuring types of satellite, designing the working mode of the constellation system, and determining the information flow and the task flow comprise:
configuring different types of satellites according to the selected valid payload capable of acquiring the relevant detection elements; laying out the constellation system according to an order of detection elements and a degree of element correlation; selecting an observation mode and the working mode; and determining the task flow for an observation work to acquire anomaly elements, wherein a task source is an autonomous task planning initiated by general survey satellites, detailed survey satellites have on-board autonomous task planning capabilities, and observation elements acquired by satellites are transmitted within the system in a form of information flow and ultimately reach users.

5. The distributed computing-based earth's surface anomaly detection satellite group task process design method according to claim 1, wherein the real-time remote sensing constellation performing the regular search on the region to acquiring the remote sensing element comprises:
for a known forest and grassland-covered region, prioritize acquiring plant canopy data related to forests and grasslands, as well as multi-band infrared data used to prevent or determine forest and grassland fires; for a known water-covered region, prioritize acquiring backscatter data and multispectral /hyperspectral data; for a known artificial earth's surface region, prioritize acquiring high-resolution data; for a known bare soil region, prioritize acquiring multispectral and infrared data; and for a near-surface atmospheric region, prioritize acquiring hyperspectral, infrared and scattering data.

6. The distributed computing-based earth's surface anomaly detection satellite group task process design method according to claim 1, wherein the complexity levels of anomalies are classified as:
an anomaly with one observation response characteristic and having a strong characteristic being identified as a simple anomaly;
an anomaly with two response characteristics being identified as a moderately complex anomaly; and
an anomaly with three or more response characteristics being identified as a complex anomaly.

7. The distributed computing-based earth's surface anomaly detection satellite group task process design method according to claim 1, wherein a specific manner for the relay transmission of the anomaly information is as follows:
a general survey satellite preliminarily discovers the anomaly, transmits slices and position information to a subsequent satellite, and initiates a task simultaneously;
earth's surface anomaly information identified by both the general survey satellite and a detailed survey satellite are transmitted to ground via real-time links between general survey satellites;
both the general survey satellites and the detailed survey satellites have a capability to access an existing space-based information network, comprising data transmission, relay, Beidou short message, and an upcoming satellite network low-orbit communication system.
